Europäisches Patentamt

European Patent Office

Office européen des brevets

(11) Veröffentlichungsnummer: **0 010 624
B1**

# (12) EUROPÄISCHE PATENTSCHRIFT

(45) Veröffentlichungstag der Patentschrift:
23.06.82

(21) Anmeldenummer: 79103702.1

(22) Anmeldetag: 28.09.79

(51) Int. Cl.³: **H 01 L 21/00,** H 01 L 21/31,
H 01 L 29/78

(54) Verfahren zur Ausbildung sehr kleiner Maskenöffnungen für die Herstellung von Halbleiterschaltungsanordnungen.

(30) Priorität: 03.11.78 US 957605

(43) Veröffentlichungstag der Anmeldung:
14.05.80 Patentblatt 80/10

(45) Bekanntmachung des Hinweises auf die Patenterteilung:
23.06.82 Patentblatt 82/25

(84) Benannte Vertragsstaaten:
DE FR GB

(56) Entgegenhaltungen:
DE-A-2 818 090
US-A-3 846 822
US-A-3 863 330
US-A-4 037 307
TECHNICAL DIGEST 1974
INTERNATIONAL ELECTRON
DEVICES MEETING, 9—11 Dezember 1974, IEEE,
New York, US, H. KAMIOKA et al.:
»A new submicron ermitter formation
with reduced base resistance for ultra-high
speed devices«, Seiten 279—282

(73) Patentinhaber: **International Business Machines
Corporation, Armonk, N.Y. 10504 (US)**

(72) Erfinder: **Ho, Irving Tze, 2 High Point Drive,
Poughkeepsie New York, 12603 (US)**
Erfinder: **Riseman, Jacob, 38 Barnard Avenue,
Poughkeepsie New York, 12603 (US)**

(74) Vertreter: **Gaugel, Heinz, Dipl.-Ing., Schönaicher
Strasse 220, D-7030 Böblingen (DE)**

IEEE TRANSACTIONS ON ELECTRON DEVICES,
Band ED-25, Nr. 6, Juni 1978, New York,
US, TZU-HWA-HSU: »Low-noise microwave
bipolar transistor with sub-half micrometer
ermitter width«, Seiten 723—730
IBM TECHNICAL DISCLOSURE BULLETIN,
Band 21, Nr. 9, Februar 1979, New York,
US, J. L. DEINES et al.:
»Process for realization of submicron
geometries«, Seiten 3628—3629

## Verfahren zur Ausbildung sehr kleiner Maskenöffnungen für die Herstellung von Halbleiterschaltungsanordnungen

Die Erfindung bezieht sich auf Verfahren zur Ausbildung mindestens einer Maskenöffnung im Submikrometerbereich im Verlauf der Herstellung einer ein Siliciumsubstrat enthaltenden Halbleiterschaltungsanordnung sowie auf Verfahren zur Herstellung einer doppeltdiffundierten Feldeffekt-Halbleiteranordnung bzw. einer Bipolartransistoren enthaltenden Halbleiteranordnung.

Die Komplexität integrierter Silicium-Schaltkreise hat in den letzten zehn Jahren erheblich zugenommen. Mit zunehmender Erschließung von Anwendungsgebieten für Mikroprozessoren und Kleinrechner ergab sich ein entsprechend zunehmendes Bedürfnis für eine gesteigerte Komplexität, höhere Schaltgeschwindigkeit und kleinere Abmessungen solcher integrierter Schaltkreise. Im Rahmen der Halbleiterprozesse erlaubt in erster Linie die Lithographie eine Steigerung der Komplexität der integrierten Schaltkreise. In den letzten Jahren konnten lediglich mäßige Verringerungen der erzielbaren (minimalen) Linienbreite integrierter Strukturen erreicht werden. Die hohen Steigerungen der Integrationsdichte wurden in erster Linie durch eine Senkung der photolithographischen Defektdichten erzielt. Dabei erfolgt eine allmähliche Verringerung der Linienbreiten von etwa 5 bis 10 µm auf heute etwa 3 bis 5 µm. Nahezu ausschließlich wurden ferner bisher Licht im Rahmen der Lithographieprozesses eingesetzt. Inzwischen machen jedoch die Grenzen der optischen Auflösung weitere Fortschritte zunehmend schwieriger. Für die zukünftig erforderlichen gesteigerten Packungsdichten setzt man daher heute zunehmend auf eine Lithographietechnik, die ohne Lichtstrahlung auskommt, insbesondere auf Elektronen- und Röntgenstrahlbelichtungsverfahren. Probleme dieser Art und mögliche Lösungen dafür werden eingehender behandelt in dem Artikel von B. L. Critchlow mit dem Titel »High Speed MOSFET circuits Using Advanced Lithography«, veröffentlicht in der Zeitschrift Computer, Band 9, Nr. 2, Februar 1976, Seiten 31 bis 37. In diesem Artikel kommen insbesondere die erheblichen Kosten für die erforderliche Apparatur sowie die Komplexität der Röntgen- und Elektronenstrahllithographie zum Ausdruck. Bisher besteht jedoch die Auffassung, daß diese Techniken die einzigen Alternativen für die optische Projektionsbelichtung für derart hochkomplexe integrierte Schaltkreise der zukünftig benötigten Art darstellen.

Darüber hinaus gab es weitere Bemühungen, sehr schmale Linienbreiten im Bereich von 1 µm oder darunter durch Ausweitung der standardmäßigen photolithographischen Verfahren unter Vermeidung derart kostenträchtiger und komplexer Techniken wie Elektronen- oder Röntgenstrahllithographie zu erzielen. Ein möglicher Lösungsweg ist beispielsweise in der Veröffentlichung im IBM Technical Disclosure Bulletin,

Vol. 19, No. 6, November 1976, Seiten 2057/2058 unter dem Titel »Narrow Line Widths Masking Method« beschrieben. Das dort behandelte Verfahren macht von porösem Silicium und einem zugehörigen Oxidationsprozeß Gebrauch. Ein anderes Verfahren ist in der Veröffentlichung im IBM Technical Disclosure Bulletin Vol. 20, No. 4, September 1977 auf den Seiten 1376 bis 1378 beschrieben. Dort werden polykristalline Maskierungsschichten aus Silicium benutzt, wobei die Maskenausbildung unter Einsatz einer Zwischenmaskierung aus einem oxidationshemmenden Material, z. B. im Fall von polykristallinem Silicium aus Siliciumnitrid, erfolgt. Mit diesem Verfahren lassen sich Linienbreiten unterhalb 2 µm erzielen.

In US-A-4 037 307 ist ein Verfahren zum Herstellen extrem schmaler Kanalzonen von FETs und Basiszonen von bipolaren Transistoren beschrieben, bei dem eine erste Kante in einer ersten Maskierungsschicht und eine durch diese Kante lateral definierte zweite Kante in einer zweiten Maskierungsschicht die lateralen Abmessungen bestimmen.

Aus »Technical Digest 1974 International Electron Devices Meeting«, Dez. 1974, Seiten 279 bis 282 ist ein Verfahren zum Herstellen schmaler, ausgerichteter Halbleiterzonen bekannt, bei dem eine mindestens dreischichtige Maske verwendet wird und die angestrebten lateralen Abmessungen durch Überätzen der mittleren Schicht der Maske definiert werden.

Weiterhin ist in US-A-3 846 822 die Herstellung eines FETs beschrieben, bei dem die Gate/Drain/-Sourceausrichtung durch Ausnutzung der erzielbaren Abschattung von zur Bearbeitung der Masken verwendeten schräg einfallenden Ionenstrahlen erreicht wird.

Ferner steht in der Technik des Plasma- oder reaktiven Ionenätzens eine zum Ätzen von Metallen, halbleitenden und dielektrischen Materialien für integrierte Schaltkreise entwickelte Technik mit guten Eigenschaften zur Verfügung. Insbesondere läßt sich mit dem reaktiven Ionensätzen ein anisotropisches Ätzen durchführen, mit dem hohe sogenannte Aspektverhältnisse erzielbar sind, d. h. die Ätzrate in vertikaler Richtung ist erheblich stärker ausgeprägt als die in horizontaler Richtung. Für die Prozeßdurchführung wird ein Plasma bzw. ionisiertes Gas benötigt, für das eine Vielzahl von hoch-reaktiven Bestandteilen, z. B. Ionen, freie Elektronen und freie Radikale, maßgeblich sind. Das zum Ätzen eingesetzte Plasma kann auf relativ niedrigen Temperaturen in der Größenordnung bis etwa 250° C und bei geringen Drücken im Bereich von 0,005 bis 20 Torr (etwa 0,006 bis 27 mbar) gehalten werden. Die Plasma-Bestandteile sind überwiegend freie Radikale, die die intensive Reaktivität des Plasmas bewirken. Die Ionenbesetzung in einem Plasma von niedriger Temperatur beträgt größenordnungsmäßig etwa 1% der Bestandteile. In dem Artikel »A Survey of Plasma-Etching Processes«, von Richard L. Bersin, veröffentlicht in der Zeitschrift Solid State Technology, Mai 1976, Seiten 31 bis 36 ist sehr eingehend, das Plasmaätzen sowie dessen Anwendung auf halbleitende Materialien behandelt. Ein solcher Prozeß wurde auch bereits eingesetzt, um Gräben oder Öffnungen in Silicium-Halbleiterkörpern auszubilden, vgl. z. B. die US-Patentschriften 3 966 577 (A. K. Hochberg), 4 104 086 (J. A. Bondur sowie 4 139 442 (J. A. Bondur u. a.). Weitere Einzelheiten über die Technologie des reaktiven Ionenätzens bzw. Plasmaätzens können der DE-Offenlegungsschrift 26 17 483 (J. N. Harvilchuck u. a.) entnommen werden. Das von Harvilchuck angegebene HF-induzierte Plasma benutzt als Bestandteil reaktives Chlor, Brom oder Jod. In der zuletzt genannten Schrift findet sich auch eine nähere Beschreibung der HF-Entladekammer zur Durchführung des Verfahrens sowie der einzelnen Prozeßbedingungen.

Die Erfindung, wie sie in den Ansprüchen gekennzeichnet ist löst die Aufgabe, den Anwendungsbereich konventionell ausgestatteter Lithographieverfahren zu weiter verringerten Dimensionen (Linienbreiten) bis in den Submikrometerbereich hinein auszudehnen.

Zusammengefaßt werden in dem Verfahren gemäß dieser Erfindung auf einem Substrat zunächst das Substrat teilweise bedeckende Bereiche einer ersten Isolierschicht ausgebildet, so daß im wesentlichen horizontale sowie im wesentlichen vertikale Oberflächen vorliegen. Darüber wird eine zweite Isolierschicht aus gegenüber der ersten Isolierschicht verschiedenem Material aufgebracht und einem reaktiven Ionenätzverfahren derart unterzogen, daß die horizontalen Bereiche der zweiten Isolierschicht abgetragen werden und lediglich sehr schmale Bereiche dieser Schicht auf den vertikal gerichteten Oberflächenbereichen der ersten Isolierschicht bzw. den betreffenden Bereichen des Substrats verbleiben. Anschließend wird eine thermische Oxidation der freiliegenden Substratbereiche vorgenommen und zur endgültigen Freilegung der gewünschten Maskenöffnung(en) die dort befindlichen Bereiche der zweiten Isolierschicht entfernt. Damit lassen sich kleinere als die mit üblichen photolithographischen Verfahren bestimmten Minimaldimensionen erzielen.

Die Erfindung wird im folgenden anhand von Ausführungsbeispielen unter Zuhilfenahme der Zeichnungen näher erläutert. Es zeigt

Fig. 1A bis 1G den grundsätzlichen Verfahrensablauf gemäß der Erfindung;

Fig. 2A bis 2D einen Verfahrensablauf zur Bildung einer doppeldiffundierten FET-Schaltkreisstruktur und

Fig. 3A bis 3F einen Verfahrensablauf zur Herstellung einer Bipolar-Transistorstruktur mit einem Emitter im Submikrometer-Bereich.

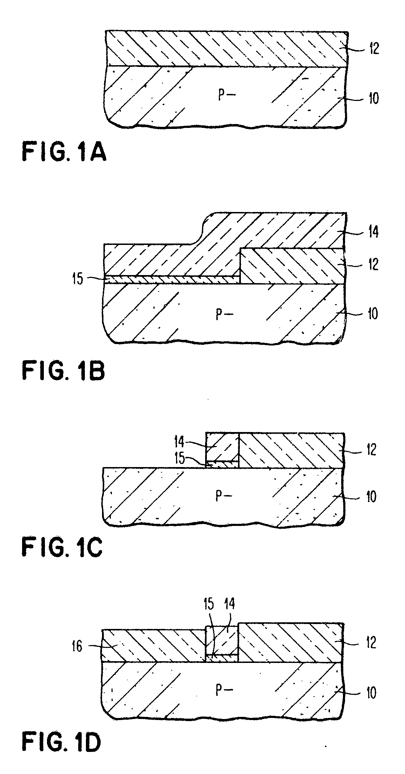

Auf den grundsätzlichen Verfahrensablauf gemäß der Erfindung soll im folgenden anhand der Fig. 1A bis 1E eingegangen werden. Fig. 1A zeigt in starker Vergrößerung einen kleinen Ausschnitt aus einem Siliciumkörper, in dem ein hochintegrierter Schaltkreis ausgebildet werden soll. Dabei wird von einem einkristallinen Siliciumkörper 10 ausgegangen. Eine Isolierschicht 12 wird auf einer Hauptfläche des P-Substrats 10 aufgebracht. Das Siliciumsubstrat 10 kann gleichermaßen vom P oder N Leitungstyp sein. Die mit 12 bezeichnete Schicht kann aus einer Vielzahl von Materialien oder Kombinationen von Materialien bestehen, wozu insbesondere Siliciumdioxid, Siliciumnitrid und Aluminiumtrioxid gehören. Diese erste Isolierschicht 12 wird nun entsprechend Fig. 1B teilweise mittels eines Ätzverfahrens entfernt, wozu vorzugsweise ein reaktives Ionenätzverfahren der in der eingangs angezogenen Literatur näher behandelten Art eingesetzt wird. Die zugehörige Prozeßatmosphäre hängt dabei von dem jeweiligen Material der betreffenden Isolierschicht ab, vgl. den ebenfalls eingangs erwähnten Aufsatz von Richard L. Bersin »A Survey of Plasma-Etching Processes«. Eine zweite Isolierschicht 14 aus einem anderen Material wird anschließend auf die somit vorliegende Oberfläche aufgebracht, wobei durch den vorangehenden Ätzprozeß der ersten Isolierschicht 12 als Oberfläche im wesentlichen horizontale sowie im wesentlichen vertikale Oberflächenbereiche vorliegen. Wo es sich bei der zweiten Isolierschicht um ein Material, z. B. Siliciumnitrid, handelt, das beim direkten Aufbringen auf Silicium Spannungen im Silicium verursachen kann, kann zunächst, z. B. mittels thermischer Oxidation der Unterlage, eine sehr dünne Schicht 15 aus Siliciumdioxid darunter gebildet werden. Die mit 12 bezeichneten Schicht kann beispielsweise gleichermaßen aus Siliciumdioxid bestehen.

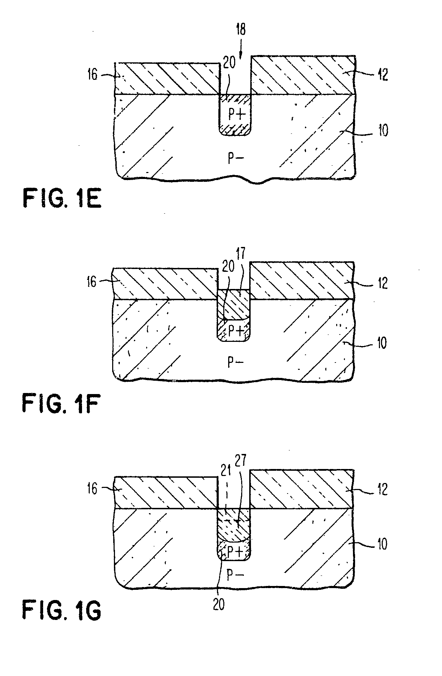

Die soweit gebildete in Fig. 1B gezeigte Struktur wird anschließend in eine reaktive Ionenätzatmosphäre eingebracht, die zum Abtragen der zweiten Isolierschicht 14 ausgelegt ist. Durch den reaktiven Ionenätzvorgang wird die zweite Isolierschicht 14 von den im wesentlichen horizontalen Oberflächenbereichen abgetragen, wobei die im wesentlichen vertikalen Oberflächenbereiche praktisch nicht angegriffen werden. Das Ergebnis des reaktiven Ionenätzens ist in Fig. 1C illustriert, wo lediglich ein sehr schmal dimensionierter Bereich der zweiten Schicht 14 noch auf der vertikal gerichteten Oberfläche verblieben ist. Die Bereiche des einkristallinen Siliciumsubstrats, die nun entweder freiliegen oder eine nur dünne Schicht 15 aus Siliciumdioxid tragen, werden einer thermischen Oxidationsatmosphäre aus z. B. Sauerstoff und Wasserdampf bei 970° C unterworfen, um die mit 16 bezeichnete thermische Siliciumdioxidschicht aufwachsen zu lassen. Vorzugsweise mit einem chemischen Ätzmittel wird dann die Siliciumnitridschicht 14 entfernt, ohne die Siliciumdioxidschicht 16 oder die erste Isolierschicht 12 anzugreifen, die ebenfalls aus Siliciumdioxid bestehen kann. Soweit eine dünne Siliciumdioxidschicht 15 in der erwähnten Weise vorhanden ist, kann diese ebenfalls in einfacher Weise chemisch abgeätzt werden. Die resultierende Struktur entsprechend Fig. 1E weist somit eine sehr klein dimensionierte Maskenöffnung auf, deren Größe direkt mit der Schichtdicke der zweiten Isolierschicht zusammenhängt. Diese Schichtdicke läßt sich sehr genau einstellen, so daß Maskenöffnungen im Submikrometerbereich zwischen etwa 100 bis 1000 nm gut erreichbar sind. Im nächsten Verfahrensschritt kann entweder mittels thermischer Diffusion oder Ionenimplantation ein Dotierungsstoff durch die Maskenöffnung 18 eingebracht werden. In Fig. 1E ist ein P+ Dotierungsgebiet 20 gezeigt, das z. B. als sog. Kanalstopper für MOS-Feldeffektelemente wirken kann. Solche Dotierungen können gleichermaßen für Bipolar-Elemente im Rahmen der Sperrschichtisolation durchgeführt werden.

Entsprechend Fig. 1F kann alternativ auch ein mit 17 bezeichnetes dielektrisches Gebiet als Kanalstopper durch die so hergestellte schmale Maskenöffnung gebildet werden. Dazu wird im Bereich der Öffnung auf dem P+ Dotierungsgebiet 20 eine thermische Siliciumdioxidschicht erzeugt. Als weitere Alternative kann nach der P+ Diffusion und vor dem thermischen Aufwachsen einer Oxidschicht im Silicium eine kleine Vertiefung 21 von einigen 100 nm geätzt werden, um dann beim Aufwachsen einer thermischen Oxidschicht 27 die in Fig. 1G gezeigte und hinsichtlich ihrer Oberflächenebenheit verbesserte Struktur zu erhalten. Durch das P+ Dotierungsgebiet 20 wird bei dieser Art der dielektrischen Isolation der Kanalverhinderungseffekt in seiner Wirksamkeit erhöht.

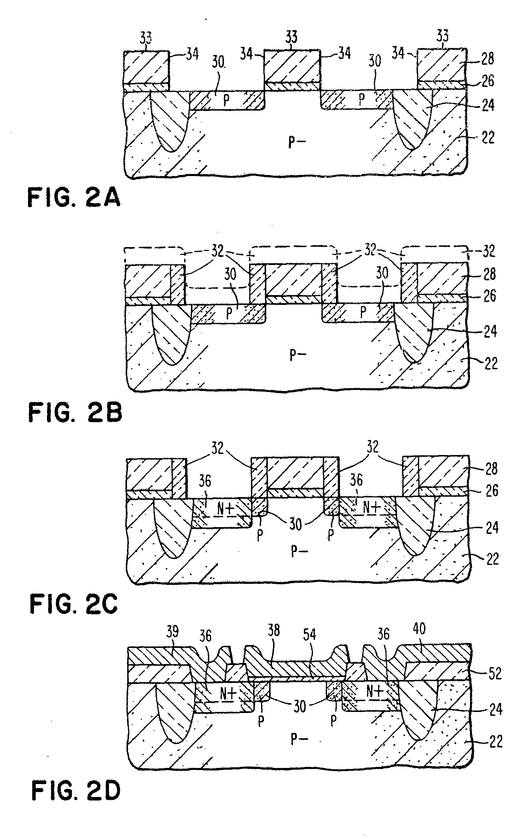

Anhand der Fig. 2A bis 2D soll im folgenden auf ein Verfahren zur Herstellung einer doppeltdiffundierten Feldeffekttransistorstruktur mit einem flachen Dotierungsprofil und einer kurzen Kanallänge eingegangen werden. Fig. 2A zeigt in starker Vergrößerung einen kleinen Ausschnitt aus einem einkristallinen Siliciumsubstrat, in dem die entsprechende Schaltung vorgesehen werden soll. Ausgegangen wird von einem P⁻-Substrat 22 aus einkristallinem Silicium mit einer kristallographischen (100)-Orientierung und einem spezifischen Widerstandswert in der Größenordnung von 1 bis 20 Ω · cm. Zur Isolation verschiedener einkristalliner Bereiche im Siliciumsubstrat 22 sind teilweise oder vollständig dielektrische Isolationsgebiete 24 vorgesehen. Als dielektrisches Material kommt Siliciumdioxid, Siliciumnitrid oder Glas in Frage. Als vorzugsweise Isolationsmethode für hochintegrierte Schaltkreise wird eine teilweise dielektrische Isolation der in Fig. 2A gezeigten Art gewählt. Zur Bildung dieser Isolationsgebiete gibt es viele Möglichkeiten, wobei vorzugsweise von dem in der eingangs erwähnten US-Patentschrift 4 104 086 näher beschriebenen Verfahren Gebrauch gemacht wird.

Mittels thermischer Oxidation oder durch chemischen Niederschlag aus der Gasphase wird eine dünne Siliciumdioxidschicht 26 mit einer Schichtdicke in der Größenordnung von 100 nm gebildet. Das thermische Aufwachsen der Schicht 26 kann in einer Sauerstoff-Wasserdampfatmosphäre bei einer Temperatur von etwa 970° C erfolgen. Das Aufbringen von Siliciumdioxid mittels chemischen Niederschlags aus der Gasphase verwendet $SiH_4$ und $O_2$ bei etwa 450° C oder $SiH_2Cl_2$ und $N_2O$ bei etwa 800° C und Atmosphärendruck oder geringer.

Die mit 28 bezeichnete Schicht, in diesem Fall Siliciumnitrid, wird durch chemischen Niederschlag aus der Gasphase unter den folgenden Prozeßbedingungen hergestellt: $SiH_4$, $NH_3$ und $N_2$ Trägergas bei einer Temperatur von etwa 700 bis 1100° C und Atmosphärendruck oder geringer, vgl. die US-Patentschrift 4 089 992. Alternativ können statt der Siliciumdioxid- und Siliciumnitridschicht auch andere Isolierschichten oder Kombinationen davon eingesetzt werden.

Mittels standardmäßiger Photolithographie- und Ätzverfahren werden in der ersten (Doppel)Schicht 26, 28 Öffnungen hergestellt. Diese Öffnungen befinden sich an den für Source und Drain der doppeltdiffundierten MOS-Feldeffektelemente vorgesehenen Stellen. P dotierende Ionen werden durch diese Öffnungen zur Bildung der mit 30 bezeichneten P Dotierungsbereiche im einkristallinen Siliciumsubstrat 22 eingebracht. Als entsprechender Dotierungsstoff kommt typisch Bor in Frage, wobei die mit 30 bezeichneten Gebiete mittels thermischer Diffusion oder Ionenimplantation hergestellt werden können.

Auf die resultierende Oberfläche mit ihren sowohl im wesentlichen horizontalen Oberflächenbereichen 33 als auch mit ihren vertikalen Oberflächenbereichen 34 wird dann eine zweite Isolierschicht 32 aufgebracht. Im beschriebenen Ausführungsbeispiel mag diese Schicht 32 aus chemisch niedergeschlagenem Siliciumdioxid bestehen, was mit den oben erwähnten Verfahren erfolgen kann. Die Schichtdicke der Siliciumdioxidschicht beträgt dabei etwa 50 bis 2000 nm, wobei eine Schichtdicke von 400 nm vorgezogen wird. Bei einer Schichtdicke von mehr als 2000 Ångström treten Ladungstransportprobleme und längere Ätzzeiten auf. Bei Schichtdicken kleiner 50 nm drohen Kurzschlüsse.

Die soweit behandelte Anordnung wird dann in eine geeignete Atmosphäre zum reaktiven Ionensätzen der Schicht 32 eingebracht. Dadurch werden im wesentlichen die horizontalen Bereiche der Schicht 32 in der in Fig. 2B in unterbrochenen Linien angezeigten Weise entfernt und lediglich die sehr schmalen vertikal sich erstreckenden Bereiche dieser Schicht 32 belassen.

N+ Ionen werden nun durch die Source- und Drain-Öffnungen zur Erzeugung der mit 36 bezeichneten Gebiete eingebracht. Auch dazu kann wieder eine thermische Diffusion oder Ionenimplantation mit Phosphor, Arsen, Antimon als N-Dotierungsstoff eingesetzt werden. Dabei erstrecken sich die mit 36 bezeichneten N+ Gebiete zwar tiefer in das Substrat hinein als die ursprünglichen P-Bereiche 30, wegen der engeren Öffnung ist ihre seitliche Erstreckung jedoch geringer. Die Verringerung der Öffnungsweite erfolgte dabei durch die auf der vertikal gerichteten Oberfläche aufgebrachte zweite Schicht 32 entsprechender Dicke. Die resultierende Struktur ist in Fig. 2C gezeigt. Als bevorzugte physikalische Dimensionen dieser Struktur gilt für das verbleibende P-Gebiet eine Breite von etwa 500 nm bei einer Tiefe von etwa 200 nm. Das mit 36 bezeichnete N + Gebiet weist eine Tiefe von etwa 300 nm auf. Im Vergleich zu einer mehr konventionellen doppeltdiffundierten FET-Struktur, bei der das Gebiet 36 vollständig vom P Material des effektiven Kanals umgeben ist, weist die in Fig. 2C gezeigte Struktur eine geringere parasitäre Source-/Drain-Kapazität auf. Die FET-Anordnung kann anschließend durch Herstellen der Gate-Elektrode 38 sowie der Source- und Drain-Elektroden 39 und 40 mittels konventioneller zugehöriger Verfahren fertiggestellt werden. Typisch für eine Weiterbehandlung ist beispielsweise, daß die Bereiche 28, 26 und 32 durch Ätzen entfernt werden und eine mit 52 bezeichnete Isolierschicht, z. B. aus Siliciumdioxid mit einer Dicke von etwa 300 bis 1000 nm gebildet wird, vgl. Fig. 2D. Diese Isolierschicht wird teilweise wieder zur Freilegung des Gate-Bereichs entfernt und dort eine thermische Gate-Oxidschicht 54 mit einer Dicke von etwa 10 bis 100 nm gebildet. Zur Herstellung der Source- und Drain-Kontaktlöcher werden an den dafür in Frage kommenden Stellen ebenfalls die entsprechenden Bereiche der Schicht 52 entfernt. Die Gate-Elektrode 38 sowie die Source- und Drain-Kontakte 39 und 40 werden dann durch Niederschlagen einer elektrisch leitfähigen Schicht erzeugt, z. B. einer Aluminiumschicht von 500 nm Dicke. Soweit im Rahmen dieses Ausführungsbeispiels das mit 36 bezeichnete Gebiet im Anschluß an die Diffusion des Gebietes 30 gezeigt ist, kann diese Verfahrensfolge gleichermaßen auch umgekehrt werden. In dem Fall wird zunächst die vertikale Seitenflächenbeschichtung 32 durch reaktives Ionenätzen gebildet und das mit 36 bezeichnete Gebiet eingebracht. Dann wird die mit 32 bezeichnete Beschichtung abgeätzt und die Dotierung für das mit 30 bezeichnete Gebiet eingebracht.

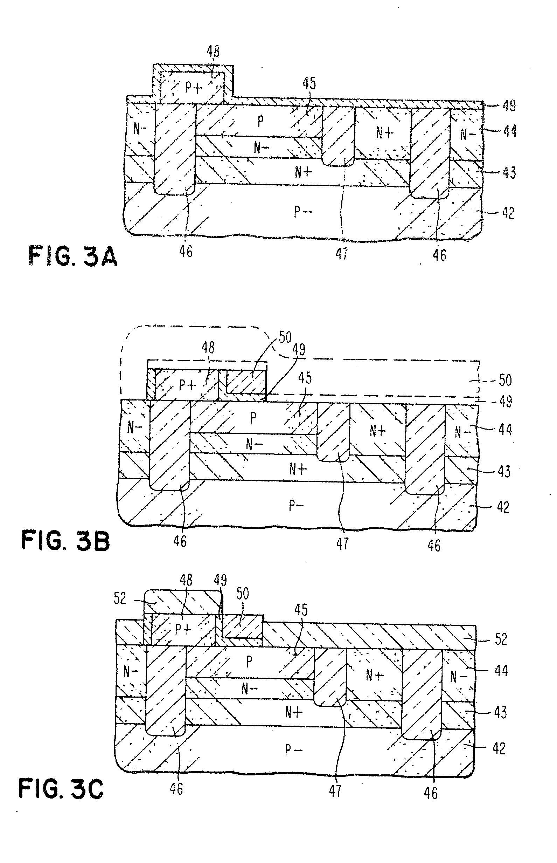

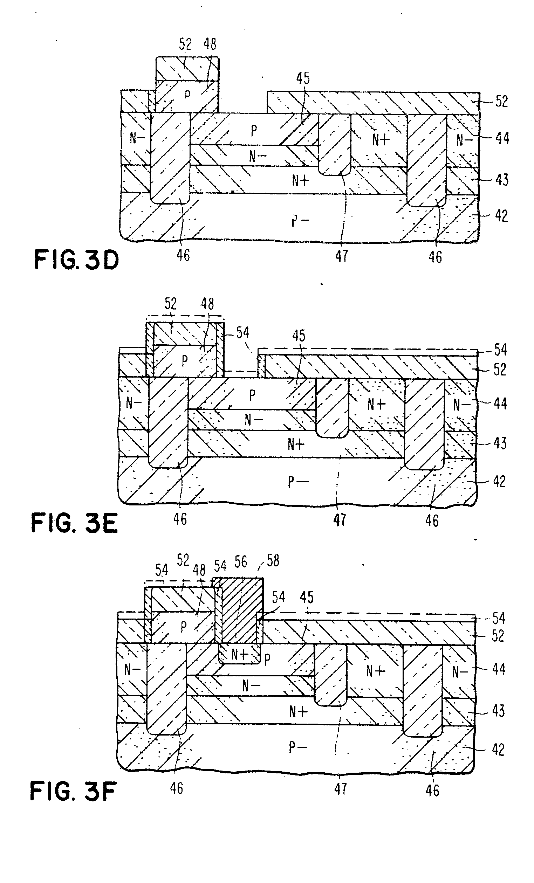

Anhand der Fig. 3A bis 3F soll nun auf ein Verfahren zur Herstellung eines integrierten Schaltkreises in Bipolar-Technologie mit einem kleinen Emitter im Submikrometerbereich eingegangen werden. Fig. 3A zeigt wieder in starker Vergrößerung einen kleinen Ausschnitt aus einem Siliciumkörper, in dem die Schaltung vorgesehen werden soll. Im Rahmen des Ausführungsbeispiels soll der Aufbau eines NPN-Transistors erläutert werden, in gleicher Weise kann unter Verwendung entgegengesetzter Leitungstypen eine PNP-Transistorstruktur aufgebaut werden. In einem P- Substrat 42 aus einkristallinem Silicium ist eine durchgehende N + Dotierung für einen Subkollektor 43 angeordnet. Auf die Substratoberfläche ist anschließend eine N-°dotierte Epitaxieschicht 44 aufgewachsen. Bei diesen Verfahrensschritten handelt es sich um Standardprozesse, die bei der Herstellung von beispielsweise NPN-Bipolartransistoren üblich sind. Bei dem Substrat handelt es sich typisch um ein einkristallines Siliciumsubstrat mit einer kristallographischen ⟨100⟩-Orientierung und einem spezifischen Widerstandswert in der Größenordnung von 10 bis 20 $\Omega \cdot$ cm. Die Subkollektordiffusion wird mittels Arsen bei einer Oberflächenkonzentration von etwa $10^{20}$/cm$^3$ und bei etwa 1000 bis 1200° C in 100 bis 300 Minuten durchgeführt.

Die Epitaxieschicht 44 wird mit konventionellen Verfahren hergestellt, z. B. unter Verwendung von SiCl$_4$/H$_2$- oder SiH$_4$/H$_2$-Mischungen bei Temperaturen von etwa 1000 bis 1200° C. Während des Aufwachsens der Epitaxieschicht wandern die in der N + Schicht enthaltenen Dotierungsatome in die Epitaxieschicht hinein. Die Dicke der Epitaxieschicht beträgt für hochintegrierte Schaltungen weniger als etwa 2 μm. Auf der Oberfläche der Epitaxieschicht wird eine (nicht dargestellte) Maskierung, z. B. aus thermisch aufgewachsenem Siliciumdioxid, gebildet und darin mittels geeigneter Photolithographie- und Ätzverfahren ein Muster aus Maskenöffnungen erzeugt, die sich an den für die dielektrische Isolation zwischen den einkristallinen Siliciumbereichen sowie den für die Trennung des Basis-/Emitterbereichs vom Kollektoranschlußbereich vorgesehenen Stellen befinden. In Fig. 3A sind mit 46 die dielektrischen Gebiete zur Isolation der einkristallinen Bereiche untereinander bezeichnet und entsprechend mit 47 ein Trenngebiet zwischen dem Basis-/Emitterbereich einerseits und dem Kollektoranschlußbereich andererseits. Zur Bildung dieser dielektrischen Gebiete gibt es vielfältige Möglichkeiten, wobei bevorzugt ein Maskierungs- und reaktiver Ionenätzschritt der in der bereits erwähnten US-Patentschrift 4 104 086 näher erläuterte Art eingesetzt werden kann. Danach wird mittels reaktivem Ionenätzen durch die Maskenöffnungen ein Vertiefungsmuster im Substrat erzeugt, worauf diese Vertiefungen zur Bildung der mit 46 und 47 bezeichneten Bereiche mit Siliciumdioxid aufgefüllt werden.

Die Oberfläche der resultierenden Struktur wird dann in üblicher Weise mit einer Maskierungsschicht aus Siliciumdioxid versehen, in der mittels an sich bekannter Photolithographie- und Ätzverfahren an den für die Basisgebiete vorgesehenen Stellen Öffnungen erzeugt werden. Ein P-dotiertes Basisgebiet 45 wird dann mittels Ionenimplantation oder thermischer Diffusion bei einer Oberflächenkonzentration von ungefähr $5 \cdot 10^{19}$/cm$^3$ und einer Temperatur von etwa 925° C über 40 Minuten erzeugt. Anschließend wird alles Siliciumdioxid von der Oberfläche abgetragen und eine Schicht 48 aus polykristallinem Silicium mittels chemischem Niederschlag aus der Gasphase mit einer Schichtdicke von 500 nm in einem der oben erwähnten Verfahren aufgebracht.

Die mit 48 bezeichnete Schicht dient dabei als Anschluß für das Basisgebiet 45, weshalb die Schicht 48 in diesem Falle eines P Basisgebietes P+ dotiert ist. Nach dem Ätzen liegen Bereiche dieser Schicht 48 lediglich noch über den Basisgebieten und über den dielektrischen Trenngebieten vor. Die resultierende Struktur ist in Fig. 3A gezeigt, wobei über der gesamten Oberfläche noch die mit 49 bezeichnete dünne thermisch gebildete Siliciumdioxidschicht dargestellt ist. Die Dicke der Schicht 49 beträgt etwa 10 bis 50 nm. Bezüglich dieser ersten Beschichtung liegen nun im wesentlichen horizontale sowie im wesentlichen vertikale Oberflächenbereiche vor. Auf die Oberfläche wird anschließend eine zweite Isolierschicht 50 aus einem anderen Material als der ersten Schicht aufgebracht. In diesem Ausführungsbeispiel wird dafür eine Siliciumnitridschicht bevorzugt. Das Aufbringen des Siliciumnitrids erfolgt wieder mittels chemischen Niederschlags aus der Gasphase in einem Verfahren der oben erwähnten Art. Die Dicke dieser zweiten Isolierschicht soll zwischen 300 und 800 nm, vorzugsweise 500 nm betragen. Durch die Dicke dieser Schicht wird die Größe der gewünschten Emitteröffnung maßgeblich bestimmt.

Die in Fig. 3B gezeigte Struktur wird dann in eine geeignete Atmosphäre zum reaktiven Ionenätzen des Siliciumnitrids eingebracht, wobei die Siliciumnitridschicht 50 im wesentlichen von allen horizontalen Oberflächen abgetragen und lediglich auf den vertikal gerichteten Oberflächen belassen wird. Durch die unterbrochenen Linien ist in Fig. 3B die Nitridschicht 50 vor dem reaktiven Ionensätzen angedeutet. Bei diesem Ausführungsbeispiel wird durch den reaktiven Ionensätzvorgang auch die dünne Siliciumdioxidschicht 49 abgetragen. Auf den derart freigelegten Silicium- bzw. polykristallinen Siliciumbereichen wird nun eine Siliciumdioxidschicht 52 durch einen thermischen Aufwachsprozeß gebildet. Die Dicke der Schicht 52 beträgt etwa 100 bis 500 nm. Es ist von Bedeutung, daß die mit 52 bezeichnete Schicht erheblich dicker als die mit 49 bezeichnete Schicht ist.

Der schmale Siliciumnitridbereich 50 wird mittels eines geeigneten Ätzmittels abgetragen, z. B. mittels heißer $H_3PO_4$ oder in einem geeigneten Plasma. Die verbleibende dünne Siliciumdioxidschicht 49 unterhalb der Siliciumnitridschicht 50 wird mittels gepufferter Flußsäure oder einem geeigneten Plasma ebenfalls geätzt. Dieser Ätzvorgang wird auch die mit 52 bezeichnete Schicht angreifen, wobei jedoch nur ein geringer Prozentsatz dieser Schicht abgetragen wird.

Die in Fig. 3D gezeigte Struktur wird dann einer thermischen Oxidationsatmosphäre in Form von Wasserdampf und Sauerstoff bei etwa 970°C unterworfen, um eine dünne Siliciumdioxidschicht 54 darüber zu bilden. Die daraus resultierende Struktur zeigt Fig. 3E. Daran schließt sich nochmals ein reaktiver Ionenätzprozeß an, um alle Bereiche der Schicht 54 mit Ausnahme der Seitenfläche zu entfernen. Mittels thermischer Diffusion oder Ionenimplantation mit Arsen oder Phosphor als Emitterdotierungsstoff wird schließlich das sehr kleine Emittergebiet 56 erzeugt. Ein geeigneter Metallanschluß 58 wird in bekannter Weise durch Aufdampfen eines Metalls und anschließende Formgebung mittels standardmäßiger Photolithographie- und Ätzverfahren ausgebildet, wodurch die verschiedenen Elemente der integrierten Schaltkreise in der gewünschten Weise durch ein Leiterzugmuster miteinander verbunden werden.

## Patentansprüche

1. Verfahren zur Ausbildung mindestens einer Maskenöffnung im Submikrometerbereich im Verlauf der Herstellung einer ein Siliciumsubstrat enthaltenden Halbleiterschaltungsanordnung, dadurch gekennzeichnet, a) daß zunächst über dem Siliciumsubstrat (z. B. 10 in Fig. 1B) mittels an sich bekannter Aufbringungs- und Formgebungsverfahren des Substrat teilweise bedeckende Bereiche einer ersten Isolierschicht (12) ausgebildet werden, die neben im wesentlichen horizontalen Oberflächen an den Rändern im wesentlichen vertikale Oberflächen aufweisen, b) daß darauf eine diese im wesentlichen horizontalen sowie im wesentlichen vertikalen Oberflächen der ersten Isolierschicht sowie die freiliegenden Bereiche des Substrates bedeckende zweite Isolierschicht (14) aus einem gegenüber der ersten Isolierschicht verschiedenen Material aufgebracht wird, c) daß diese zweite Isolierschicht (14) einem reaktiven Ionenätzverfahren derart unterzogen wird, daß die horizontalen Bereiche dieser Schicht abgetragen werden und lediglich sehr schmale Bereiche der zweiten Isolierschicht (14) auf den vertikal gerichteten Oberflächenbereichen der ersten Isolierschicht (12) sowie den betreffenden Bereichen des Substrats (10) verbleiben, d) daß anschließend eine thermische Oxidation (z. B. Schicht 16 in Fig. 1D) der freiliegenden Substratbereiche vorgenommen wird und e) daß schließlich zur Freilegung der sehr kleinen Maskenöffnung(en) (z. B. 18 in Fig. 1E) das dort noch befindliche Material der zweiten Isolierschicht (14) entfernt wird.

2. Verfahren nach Anspruch 1, dadurch gekennzeichnet, daß die erste Isolierschicht (12) aus Siliciumdioxid und die zweite Isolierschicht (14) aus Siliciumnitrid oder Aluminiumoxid besteht.

3. Verfahren nach Anspruch 2, dadurch gekennzeichnet, daß unter der Siliciumnitridschicht in den von der ersten Isolierschicht nicht bedeckten Bereichen des Substrates eine dünne Schicht (z. B. 15 in Fig. 1B) aus Siliciumdioxid vorgesehen wird, die nach Entfernung des nach der Ionenätzung verbliebenen Materials der zweiten Isolierschicht ebenfalls entfernt wird.

4. Verfahren nach einem der Ansprüche 1 bis 3, dadurch gekennzeichnet, daß durch die so hergestellte(n) Maskenöffnung(en) mittels Diffusion oder Ionenimplantation eine Dotierung des jeweiligen Substratbereiches sowie ggf. eine anschließende Reoxidation vorgenommen wird (Fig. 1E, 1F).

5. Verfahren nach Anspruch 4, dadurch gekennzeichnet, daß zur Erzielung einer verbesserten Oberflächenplanarität vor dem Reoxidationsschritt ein teilweiser Abtrag des betreffenden Substratmaterials vorgenommen wird (Fig. 1G).

6. Verfahren zur Herstellung einer doppeltdiffundierten Feldeffekt-Halbleiteranordnung, gekennzeichnet durch die folgenden Verfahrensschritte (Fig. 2A bis 2D):

a)  in einem Siliciumsubstrat (22) werden durch dielektrische Trennbereiche (24) einkristalline Teilbereiche gegeneinander isoliert;

b)  auf die Oberfläche wird eine erste Isolierschicht (28) aufgebracht, in der an den für Source und Drain vorgesehenen Stellen in an sich bekannter Weise Öffnungen ausgebildet werden, so daß im wesentlichen horizontale (33) sowie im wesentlichen vertikale (34) Oberflächenbereiche der Halbleiteranordnung vorliegen;

c)  durch die Öffnungen wird mittels Diffusion oder Ionenimplantation eine erste Dotierung vorgenommen zur Erzeugung von Dotierungsgebieten (30) vom Leitungstyp des Substrates;

d)  auf die im wesentlichen horizontalen sowie im wesentlichen vertikalen Oberflächenbereiche der soweit behandelten Anordnung wird eine zweite Isolierschicht (32) aus gegenüber der ersten Isolierschicht (28) verschiedenem Material aufgebracht;

e)  die zweite Isolierschicht (32) wird einem reaktiven Ionenätzverfahren derart unterzogen, daß im wesentlichen deren horizontale Oberflächenbereiche abgetragen werden und lediglich schmale vertikal gerichtete Bereiche dieser Schicht (32) auf den Seitenflächen der Öffnungen bzw. den betreffenden Bereichen des Substrats (22) verbleiben;

f)  durch die derart verkleinerten Öffnungen wird mittels Diffusion oder Ionenimplantation eine zweite Dotierung vorgenommen, durch die gegenüber der ersten Dotierung schmalere, jedoch tiefer in das Substrat hineinreichende Dotierungsgebiete (36) erzeugt werden, die vom anderen Leitungstyp als das Substrat sind;

g)  mittels an sich bekannter Verfahren werden Anschlüsse für Source und Drain sowie dazwischen die Gate-Elektroden hergestellt.

7. Verfahren nach Anspruch 6, dadurch gekennzeichnet, daß die erste Isolierschicht (28) aus Siliciumnitrid, vorzugsweise mit einer dünnen Siliciumdioxidschicht (26) darunter und die zweite Isolierschicht (32) aus Siliciumdioxid besteht.

8. Verfahren zur Herstellung einer Bipolartransistoren mit einer Emitterfläche im Submikrometerbereich enthaltenden Halbleiteranordnung, gekennzeichnet durch die folgenden Verfahrensschritte (Fig. 3A bis 3F):

a)  in einem Siliciumsubstrat (42, 43, 44) werden durch dielektrische Trennbereiche (46) einkristalline Teilbereiche gegeneinander isoliert;

b)  In mindestens einem dieser Teilbereiche wird ein Basisdotierungsgebiet (45) hergestellt, das durch ein dielektrisches Trenngebiet (47) von dem für ein Kollektoranschlußgebiet vorgesehenen Substratbereich isoliert ist;

c)  auf der Oberfläche wird ein das Basisdotierungsgebiet (45) überlappender Bereich einer ersten Schicht (48) ausgebildet, die aus leitfähigem polykristallinem Silicium mit einer dünnen Siliciumdioxid-Deckschicht darüber besteht und die neben im wesentlichen horizontalen Oberflächenbereichen am Rand im wesentlichen vertikale Oberflächenbereiche aufweist;

d)  auf die Oberfläche wird eine zweite Isolierschicht (50) aus einem demgegenüber verschiedenen Material aufgebracht;

e)  die zweite Schicht (50) wird einem reaktiven Ionenätzverfahren derart unterzogen, daß im wesentlichen deren horizontale Oberflächenbereiche abgetragen werden und lediglich schmale vertikal gerichtete Bereiche dieser Schicht (50) an den für die Emitter der Halbleiteranordnung vorgesehenen Stellen verbleiben;

f)  anschließend wird eine thermische Oxidation (Schicht 52 in Fig. 3C) der freiliegenden Substratbereiche vorgenommen;

g)  durch Entfernen der in den Emitterbereichen noch befindlichen Bereiche der zweiten Isolierschicht (50) wird das Substrat bereichsweise freigelegt, und anschließend durch die so gebildete Maskenöffnung die Dotierung der Emittergebiete (56) vorgenommen.

9. Verfahren nach Anspruch 8, dadurch gekennzeichnet, daß die zweite Isolierschicht (50) aus Siliciumnitrid besteht.

10. Verfahren nach Anspruch 8 oder 9, dadurch gekennzeichnet, daß die Basis- und/oder Emittergebiete (45 bzw. 56) direkt an die dielektrischen Trenngebiete (46, 47) angrenzend ausgebildet werden.

## Claims

1. A method of forming at least one mask opening in the submicrometer range during the manufacture of a semiconductor circuit structure comprising a silicon substrate, characterized in that a) initially, regions of a first insulator layer (12) partially covering the substrate are formed on the silicon substrate (e. g., 10 in Fig. 1B) by means of known deposition and forming processes, said regions having at their edges, in addition to substantially horizontal surfaces, substantially vertical surfaces, that b) said first insulator layer is followed by a second insulator layer (14) of a material different from that of the first layer, which covers the substantially horizontal as well as the substantially vertical surfaces of the first insulator layer as well as the bare regions of the substrate, that c) said second insulator layer (14) is subjected to reactive ion etching in such a manner that its horizontal regions are removed, leaving only very narrow regions of the second insulator layer (14) on the vertically directed surface regions of the first insulator layer (12) as well as the corresponding regions of the substrate (10), that d) the bare substrate regions are then thermally oxidized (e. g., layer 16 in Fig. 1D), and that e) finally, for baring the very narrow mask opening(s) (e. g., 18 in Fig. 1E), the material of the second insulator layer (14) contained therein is removed.

2. The method according to claim 1, characterized in that the first insulator layer (12) is composed of silicon dioxide and the second insulator layer (14) is composed of silicon nitride or aluminium oxide.

3. The method according to claim 2, characterized in that a thin layer (e. g., 15 in Fig. 1B) of silicon dioxide, which is removed after removal of the material of the second insulator layer remaining after ion etching, is provided underneath the silicon nitride layer in the regions of the substrate not covered by the first insulator layer.

4. The method according to any one of the claims 1 to 3, characterized in that through the mask opening(s) thus produced the respective substrate region is doped by diffusion or ion implantation and is subsequently reoxidized, if required (Fig. 1E, 1F).

5. The method according to claim 4, characterized in that for obtaining an improved surface planarity, the respective substrate material is partially removed (Fig. 1G) prior to the reoxidation step.

6. A method of forming a double diffused field-effect semiconductor structure, characterized by the following steps (Fig. 2A to 2D):

a) providing on a silicon substrate (22) monocrystalline partial regions isolated from one another by dielectric isolation regions (24);

b) depositing on the substrate surface a first insulator layer (28) wherein openings are formed in a known manner in the areas provided for source and drain, so that substantially horizontal surface regions (33) and substantially vertical surface regions (34) of the semiconductor structure are obtained;

c) effecting a first doping by diffusion or ion implantation through the openings for generating doping regions (30) of the conductivity type of the substrate;

d) depositing a second insulator layer (32) composed of a material different from that of the first insulator layer (28) on the suvstantially horizontal surface regions and the substantially vertical surface regions of the structure thus treated;

e) reactive ion etching the second insulator layer (32) in such a manner that its horizontal surface regions are substantially removed and only narrow vertically directed regions of said layer (32) remain on the lateral faces of the openings and the corresponding regions of the substrate (22), respectively;

f) effecting a second doping by diffusion or ion implantation through the openings thus reduced, forming doping regions (36) of a conductivity type different from that of the substrate, which are narrower than those of the first doping, but which extend more deeply into the substrate.

g) forming contacts to the source and drain and making the gate electrodes therebetween by means of know methods.

7. The method according to claim 6, characterized in that the first insulator layer (28) is composed of silicon nitride, preferably with a thin underlying silicon dioxide layer (26), and the second insulator layer (32) is composed of silicon dioxide.

8. A method of producing a semiconductor structure comprising bipolar transistors with an emitter surface in the submicrometer range, characterized by the following steps (Fig. 3A to 3F):

a) providing on a silicon substrate (42, 43, 44) monocrystalline partical regions which are isolated from one another by dielectric isolation regions (46);

b) forming in at least one of these partical regions a a base-doped region (45) which is isolated by a dielectric isolation region (47) from the substrate region provided for a collector contact region;

c) forming on the substrate surface a region of a first layer (48) overlapping the base-doped region (45) which is composed of conductive polycrystalline silicon with a thin overlying silicon dioxide layer and which, in addition to substantially horizontal surface regions, has substantially vertical surfaces regions along its edge;

d) depositing on the surface thus obrained a second insulator layer (50) of a material different from that of the underlying layer;

e) reactive ion etching the second layer (50) in such a manner that its horizontal surface regions are substantially removed, leaving only narrow vertically directed regions of this layer (50) in the areas provided for the emitters of the semiconductor structure;

f) subsequently, thermally oxidizing (layer 52 in Fig. 3C) the bared substrate regions;

g) baring regions of the substrate by removing the regions of the second insulator layer (50) still remaining in the emitter regions and subsequently doping the emitter regions (56) through the mask opening thus formed.

9. The method according to claim 8, characterized in that the second insulator layer (50) is composed of silicon nitride.

10. The method according to claim 8 or 9, characterized in that the base and/or emitter regions (45 and/or 56) are formed directly abutting the dielectric isolation regions (46, 47).

## Revendications

1. Procédé pour former au moins une ouverture de masque dans la gamme submicronique lors de la fabrication d'un circuit semi-conducteur comportant un substrat de silicium, caractérisé en ce que a) on dépose d'abord audessus du substrat de silicium (par exemple 10 sur la figure 1B), à l'aide de procédés de dépôt et de mise en forme connus, des régions d'une première couche isolante (12) recouvrant partiellement le substrat et comportant en outre, aux bords des surfaces essentiellement verticales, des surfaces essentiellement horizontales; en ce que b) on dépose sur ladite première couche une seconde couche isolante (14) d'un matériau différent de celui de la première couche, qui recouvre les surfaces essentiellement horizontales et essentiellement verticales de la première couche isolante et les régions exposées du substrat; en ce que c) on décape cette seconde couche isolante (14) par des ions réactifs de telle sorte que les régions horizontales de cette couche sont enlevées en laissant seulement des régions très étroites de la seconde couche isolante (14) sur les régions de surface verticale de la première coche isolante (12) et sur les régions correspondantes du substrat (10), en ce que d) on oxyde ensuite thermiquement les régions exposées du substrat (par exemple la couche 16 de la figure 1D); et enfin en ce que e) on enlève le matériau de la seconde couche isolante (14) qui se trouve encore dans la ou les ouvertures de masquage de très petites dimensions (par exemple 18 sur la figure 1E), pour exposer celles-ci.

2. Procédé selon la revendication 1, caractérisé en ce que la première couche isolante (12) est en dioxyde de silicium et la seconde couche isolante (14) est en nitrure de silicium ou en oxyde d'aluminium.

3. Procédé selon la revendication 2, caractérisé en ce qu'on forme sous la couche de nitrure de silicium et dans les régions du substrat non recouvertes par la première couche isolante, une mince couche (par exemple 15 sur la figure 1B) de dioxyde de silicium qui est enlevée après avoir enlevé le matériau de la seconde couche isolante subsistant après le décapage par ions réactifs.

4. Procédé selon l'une des revendications 1 à 3, caractérisé en ce qu'on dope les régions de substrat à travers la ou les ouvertures de masquage ainsi obtenues, à l'aide d'une diffusion ou d'une implantation ionique, et qu'on les réoxyde ensuite éventuellement (figures 1E, 1F).

5. Procédé selon la revendication 4, caractérisé en ce qu'on enlève partiellement le matériau de substrat pour obtenir une meilleure planarité de surface avant le processus de réoxydation (figure 1G).

6. Procédé pour fabriquer un dispositif semi-conducteur à effet de champ à double diffusion, caractérisé par les étapes de procédé suivantes (figures 2A à 2D):

a) on forme sur un substrat de silicium (22) des régions partielles monocristallines isolées les unes des autres par des régions d'isolement diélectrique (24);

b) on dépose sur la surface du substrat une première couche isolante (28) dans laquelle on forme des ouvertures de la façon connue dans les régions destinées à la source et le drain, de telle sorte qu'on obtient des régions de surface essentiellement horizontales (33) et des régions de surface essentiellement vertivales (34) du dispositif semi-conducteur;

c) on effectue un premier dopage, par diffusion ou par implantation ionique, à travers ces ouvertures afin d'obtenir des régions dopées (30) du même type de conductivité que celle du substrat;

d) on dépose une seconde couche isolante (32) d'un matériau différent de celui de la première couche isolante (28) sur les régions de surface essentiellement horizontales et les régions de surface essentiellement verticales du dispositif ainsi traité;

e) on décape par des ions réactifs la seconde couche isolante (32) de telle sorte que ces régions de surface horizontales sont essentiellement enlevées et qu'il reste seulement des régions étroites verticales de ladite couche (32) sur les faces latéralws des ouvertures ou des régions correspondantes du substrat (22);

f) on effectue un second dopage par diffusion ou par implantation ionique à travers les ouvertures ainsi diminuées et on forme ainsi des régions de dopage (36) d'un type de conductivité opposé à celui du substrat, lesdites régions étant plus étroites que celles résultant du premier dopage mais s'étendant plus profondément dans le substrat;

g) on forme, par des procédés connus, des contacts avec les régions source et drain et les électrodes de porte.

7. Procédé selon la revendication 6, caractérisé en ce que la première couche isolante (28) est en nitrure de silicium, de préférence avec une couche de dioxyde de silicium mince sous-jacente (26) et en ce que la seconde couche isolante (32) est en dioxyde de silicium.

8. Procédé pour fabriquer un dispositif semi-conducteur comportant des transistors bipolaires avec une surface d'émetteur dans la gamme submicronique, caractérisé par les étapes de procédé suivant (figures 3A à 3F):

a) on isole dans un substrat de silicium (42, 43, 44) des régions partielles monocristallines les unes des autres par des régions d'isolement diélectrique (46);

b) on forme au moins dans une de ces régions partielles une région de dopage de base (45) qui est isolée de la région de substrat destinée à la région de connexion de collecteur par une région d'isolement diélectrique (47);

c) on forme sur la surface de substrat une région d'une première couche (48) chevauchant la région de dopage de base (45) qui est composée de silicium polycristallin conducteur potant une mince couche de dioxyde de silicium superposée et qui, en plus des régions de surface essentiellement horizontales, présente des régions de surface essentiellement verticales de lang de son bord;

d) on dépose sur la surface ainsi obtenue une seconde couche isolante (50) d'un matériau qui est différent de celui de la couche sous-jacente;

e) on décape par des ions réactifs la seconde couche (50) de telle sorte que régions de surface essentiellement horizontales sont enlevées, ce qui laisse subsister seulement des régions verticales étroites de cette couche (50) dans les zones prévues pour les émetteurs du dispositif semi-conducteur;

f) on oxyde ensuite thermiquement (couche 52 de la figure 3C) les régions de substrat exposées;

g) on expose le substrat, région par région, en enlevant les régions de la seconde couche isolante (50) se trouvant encore dans les régions d'émetteur et on effectue ensuite le dopage des régions d'émetteur (56) à travers l'ouverture de masquage ainsi formée.

9. Procédé selon la revendication 8, caractérisé en ce que la seconde couche isolante (50) est en nitrure de silicium.

10. Procédé selon la revendication 8 ou 9, caractérisé en ce que les régions de base et/ou d'émetteur (45 et/ou 56) sont formées de sorte à être directement adjacentes aux régions d'isolement diélectrique (46, 47).

**FIG. 1A**

**FIG. 1B**

**FIG. 1C**

**FIG. 1D**

FIG. 1E

FIG. 1F

FIG. 1G

FIG. 2A

FIG. 2B

FIG. 2C

FIG. 2D

FIG. 3A

FIG. 3B

FIG. 3C

FIG. 3D

FIG. 3E

FIG. 3F